# EUROPÄISCHE PATENTSCHRIFT

(11) **EP 2 546 392 B1**
(45) Veröffentlichungstag und Bekanntmachung des Hinweises auf die Patenterteilung: **03.09.2014**
(21) Anmeldenummer: 12174541.8
(22) Anmeldetag: 02.07.2012
(51) Int. Cl.: H05B 3/40, C30B 15/14, C30B 30/04, C30B 35/00

(54) **Ringförmiger Widerstandsheizer zum Zuführen von Wärme zu einem wachsenden Einkristall**
Ring-shaped resistance heater for supplying heat to a growing single crystal
Chauffage à résistance annulaire destiné au guidage de la chaleur vers un monocristal croissant

(30) Priorität: 15.07.2011 DE 102011079284
(43) Veröffentlichungstag der Anmeldung: 16.01.2013
(73) Patentinhaber: Siltronic AG, 81737 München (DE)
(72) Erfinder: Knerer, Dieter, 84533 Haiming (DE); Schachinger, Werner, 84359 Simbach (DE)
(74) Vertreter: Staudacher, Wolfgang

(56) Entgegenhaltungen:
- WO-A2-2005/041278
- WO-A2-2006/130701
- WO-A2-2008/155138
- DE-A1-102007 020 239
- DE-A1-102008 035 439
- DE-A1-102009 027 436

## Beschreibung

Gegenstand der Erfindung ist ein ringförmiger Widerstandsheizer zum Zuführen von Wärme zu einem wachsenden Einkristall.

Eine Methode zur Herstellung von Einkristallen ist die Czochralski-Methode. Sie wird beispielsweise angewendet, um Einkristalle aus Silizium herzustellen. Gemäß dieser Methode wird zunächst eine Schmelze in einem Tiegel erzeugt, anschließend ein Impfkristall mit der Schmelze in Kontakt gebracht und schließlich ein am Impfkristall hängender Einkristall wachsen gelassen, indem der Impfkristall von der Oberfläche der Schmelze noch oben gezogen wird.

Es hat Vorteile, wenn dem wachsenden Einkristall mittels eines ringförmigen Widerstandsheizers, der nachfolgend auch Ringheizer genannt wird, Wärme zugeführt werden kann. So ist in der US 2004/0192015 A1 ein Verfahren beschrieben, bei dem Wärme zur Phasengrenze des wachsenden Einkristalls mittels eines Ringheizers zugeführt wird, um den axialen Temperaturgradienten an der Phasengrenze entlang des Radius des Einkristalls zu vergleichmäßigen. Ziel der Maßnahme ist, Einfluss auf die Bildung von intrinsischen Punktdefekten dahingehend zu nehmen, dass die Defekteigenschaften des gewachsenen Einkristalls in radialer Richtung möglichst einheitlich sind.

In der US6,132,507 ist erwähnt, dass ein Ringheizer auch eingesetzt werden kann, um Schwankungen des Durchmessers des Einkristalls und der Wachstumsgeschwindigkeit zu reduzieren.

WO 2005/041278 A2 beschäftigt sich mit einer Halbleiter-Kristallzüchtungsanlage und offenbart eine hochtemperaturfeste Spule zu verwenden, die aus massiven Graphitleiterstäben geformt ist und nicht gekühlt werden muss.

In der WO 2008/155138 A2 ist eine Vorrichtung zur Züchtung von Kristallen aus elektrisch leitenden Schmelzen beschrieben, mit einer Heizeinrichtung, welche als Mehrspulenanordnung von übereinander angeordneten Spulen ausgeführt ist, wobei mehrere Verbindungselemente zur Spulenstabilisierung verwendet werden.

Die Erfinder der vorliegenden Erfindung haben festgestellt, dass die Verwendung eines Ringheizers zum Zuführen von Wärme zu einem wachsenden Einkristall Schwierigkeiten bereitet, wenn gleichzeitig ein starkes externes Magnetfeld aufgebaut wird, um die Strömung in der Schmelze zu beeinflussen. In einem solchen Fall kommt es zu einer elektromagnetischen Wechselwirkung zwischen dem externen Magnetfeld und dem vom Ringheizer erzeugten Magnetfeld. Die auf den Ringheizer wirkende Lorentzkraft kann die Position der Ringheizers verändern, den Ringheizer beschädigen oder sogar zerstören.

In der US7,335,864 B2 und in der korrespondierenden WO2006/130701 A2 ist beschrieben, dass das Eigenmagnetfeld eines Widerstandsheizers reduziert werden kann, indem eine Heizspule bifilar gewickelt wird, so dass der elektrische Strom in entgegengesetzten Richtungen durch die Teilwindungen der Heizspule fließt.

Die erwähnten Schwierigkeiten können jedoch trotz Verwendung eines derartig modifizierten Ringheizers nicht zufriedenstellend beseitigt werden, weil die Wechselwirkung zwischen den Magnetfeldern, wenn auch in abgeschwächter Form, bestehen bleibt.

Es ist daher die Aufgabe der vorliegenden Erfindung, einen ringförmigen Widerstandsheizer zum Zuführen von Wärme zu einem wachsenden Einkristall bereitzustellen, der die Vorteile des in der US 2004/0192015 A1 beschriebenen Ringheizers aufweist, ohne dessen Nachteile während eines Einsatzes in Gegenwart eines starken externen Magnetfelds zu haben.

Die Aufgabe wird gelöst durch einen ringförmigen Widerstandsheizer zum Zuführen von Wärme zu einem wachsenden Einkristall, umfassend einen oberen und einen unteren Ring, die durch Ringspalte, die versetzt angeordnet sind, und die angrenzend an den Ringspalt des unteren Rings mittels einer Schleife elektrisch leitend verbunden sind, so dass die Fließrichtung von elektrischem Strom, der durch die Ringe geleitet wird, in den Ringen entgegengesetzt ist;

Verbindungselemente, die den oberen und den unteren Ring auf Abstand zusammenhalten, wobei der Abstand nicht weniger als 2 mm und nicht mehr als 150 mm beträgt; und

Stromzuführungen zum Leiten von elektrischem Strom durch den oberen und den unteren Ring, wobei die Stromzuführungen elektrisch isoliert miteinander verbunden und auf diese Weise gegen eine sie zusammendrückende oder sie auseinanderziehende Kraft eines externen Magnetfelds gesichert sind.

Der Ringheizer der vorliegenden Erfindung umfasst zwei übereinander angeordnete ringförmige Teilspulen, die nachfolgend auch als oberer und unterer Ring bezeichnet werden und die mittels einer Schleife zu einem einteiligen Bauteil verbunden sind. Beim Passieren der Schleife kehrt sich die Fließrichtung von elektrischem Strom, der durch die Teilspulen fließt, um. Der Ringheizer hat dadurch die Struktur und Eigenschaften einer bifilar gewickelten Spule.

Vorzugsweise bestehen der obere und der untere Ring und die Stromzuführungen im Wesentlichen aus Kohlenstoff, beispielsweise aus mit Kohlenstofffasern verstärktem Kohlenstoff (CFC) oder aus Graphit. Besonders bevorzugt ist Graphit, insbesondere ein Graphit-Typ mit möglichst niedrigem spezifischen Widerstand, möglichst hoher Biegefestigkeit und möglichst hoher Wärmeleitfähigkeit. Damit die Fläche des Querschnitts der Ringe möglichst klein sein kann, sollte der spezifische Widerstand vorzugsweise nicht mehr als 11 µΩm betragen. Die Biegefestigkeit sollte vorzugsweise nicht weniger als 50 MPa betragen, die Wärmeleitfähigkeit vorzugsweise nicht weniger als 120 W/mK. Die hohe Wärmeleitfähigkeit beugt dagegen vor, dass sich überhitzte Stellen ("hot spots") bilden, die den Verschleiß des Ringheizers beschleunigen.

Verbindungselemente halten den oberen und unteren Ring zusammen und in einem bestimmten Abstand zueinander. Sie kompensieren dadurch elektromagnetische Kräfte, die auf die Ringe einwirken und verhindern insbesondere, dass die Ringe unter dem Einfluss eines auf die Schmelze wirkenden Magnetfelds gegeneinander verschoben werden. Der Abstand zwischen den Ringen beträgt nicht weniger als 2 mm und nicht mehr als 150 mm. Ein kleinerer Abstand als 2 mm ist wegen des Risikos des Auftretens von elektrischen Überschlägen nicht bevorzugt, ebenso wenig ein größerer Abstand als 150 mm, weil dann die Vorteile der bifilaren Struktur des Ringheizers nicht mehr ausreichend zum Tragen kommen. Die Verbindungselemente können derart ausgebildet sein, dass an den Verbindungsstellen der obere Ring vom unteren Ring elektrisch isoliert ist. Gleichermaßen können die Verbindungselemente derart ausgebildet sein, dass sie einen Teil des durch die Ringe fließenden elektrischen Stroms ableiten. Dieser Teil sollte jeweils nicht mehr als 5 % der gesamten elektrischen Leistung betragen. Eine derartige Ausgestaltung kann beispielsweise erreicht werden, indem der obere und der untere Ring mittels einer Schraube aus mit Kohlenstofffasern verstärktem Kohlenstoff (CFC) direkt aneinandergeschraubt werden.

Der obere Ring und der untere Ring werden von Stromzuführungen getragen, die am oberen beziehungsweise unteren Ring befestigt sind. Die Stromzuführungen sind elektrisch isoliert miteinander verbunden und auf diese Weise gegen eine sie zusammendrückende oder sie auseinanderziehende Kraft gesichert, die ein starkes externes Magnetfeld hervorruft. Das starke externe Magnetfeld ist beispielsweise ein horizontales Magnetfeld oder ein Cusp-Magnetfeld, das der Schmelze aufgeprägt wird.

Es ist bevorzugt, den oberen und den unteren Ring im Bereich der Befestigungsstellen der Stromzuführungen verbreitert auszubilden. Dies stärkt die mechanische Stabilität der Ringe in diesem Bereich und reduziert die Stromdichte, so dass eine lokale Überhitzung vermieden wird.

Der Ringheizer wird eingesetzt, um einem wachsenden Einkristall Wärme zuzuführen, vorzugsweise zum Zweck der Einflussnahme auf den radialen Verlauf des axialen Temperaturgradienten an der Phasengrenze des wachsenden Einkristalls und zur Regelung des Durchmessers des wachsenden Einkristalls. Bei dem Einkristall handelt es sich vorzugsweise um einen Einkristall aus Silizium mit einem Durchmesser von nicht weniger als 300 mm, besonders bevorzugt mit einem Durchmesser von 300 mm oder 450 mm.

Die Erfindung wird nachfolgend an Hand von Figuren näher erläutert. Die Figuren zeigen besonders bevorzugte Ausgestaltungsmerkmale des Ringheizers.
Fig.1 zeigt den Ringheizer ohne Verbindungselemente und ohne Stromzuführungen in perspektivischer Darstellung.
Fig.2 zeigt den Ringheizer gemäß Fig.1 mit den Verbindungselementen und den Stromzuführungen in perspektivischer Darstellung.
Fig.3 ist eine Schnittdarstellung durch den Ringheizer im Bereich der Stromzuführungen.
Fig.4 ist eine Schnittdarstellung durch die Stromzuführungen im Bereich einer Klemmverbindung.

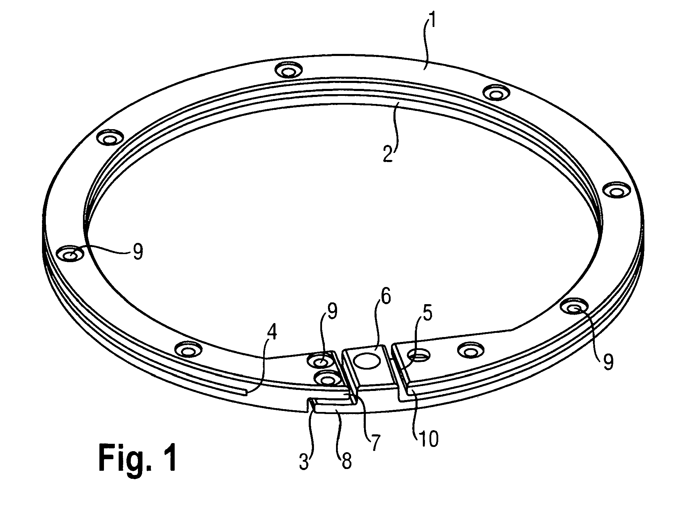

Der Ringheizer gemäß Fig.1 umfasst einen oberen Ring 1 und einen unteren Ring 2, wobei beide Ringe durch Ringspalte, die versetzt angeordnet sind, unterbrochen sind. Der Ringspalt 3 des unteren Rings grenzt an eine Schleife 4, die den oberen Ring 1 mit dem unteren Ring 2 verbindet. Der Ringspalt 5 des oberen Rings ist vorzugsweise ausreichend breit, damit Platz zum Befestigen der Stromzuführung des unteren Rings ist. Vorzugsweise ist Platz für einen Sockel 6 vorhanden, der die Dicke des unteren Rings im Bereich des Sockels erhöht, so dass sich die Befestigungsstellen der Stromzuführungen auf gleicher Höhe befinden.

Wegen der versetzten Anordnung der Ringspalte überlappen ein Ende 7 des oberen Rings und eine Ende 8 des unteren Rings im Bereich zwischen dem Sockel 6 und dem Ringspalt 3 des unteren Rings. Die Ränder des oberen Rings und des unteren Rings, insbesondere die Ränder am Außenumfang und am Innenumfang der Ringe, sind abgerundet. Das Verrunden der Ränder verringert das Risiko des Auftretens elektrischer Überschläge.

Auf den Stirnseiten der Ringe sind über den Umfang Bohrungen 9 verteilt, die deckungsgleich in Dickenrichtung durch den oberen und den unteren Ring führen. Die Bohrungen sind vorzugsweise mittig und in gleichen Abständen auf den Stirnseiten verteilt, um Asymmetrien zu vermeiden. Sie befinden sich vorzugsweise insbesondere auch an Stellen, an denen die Ringe einer besonders hohen mechanischen Belastung ausgesetzt sind. Dort, wo das Ende 7 des oberen Rings und das Ende 8 des unteren Rings überlappen, sind an Stelle von mittig angeordneten Bohrungen radial nebeneinander liegende Bohrungen 9 vorhanden. Bohrungen zum Befestigen der Ringe an Stromzuführungen befinden sich auf der Stirnseite des Sockels 6 und auf der Stirnseite eines weiteren Endes 10 des oberen Rings 1.

Es ist bevorzugt, die Ringe im Bereich von deren Enden und im Bereich des Sockels 6 zu verbreitern, um dort die mechanische Stabilität zu erhöhen und die Stromdichten zu verringern.

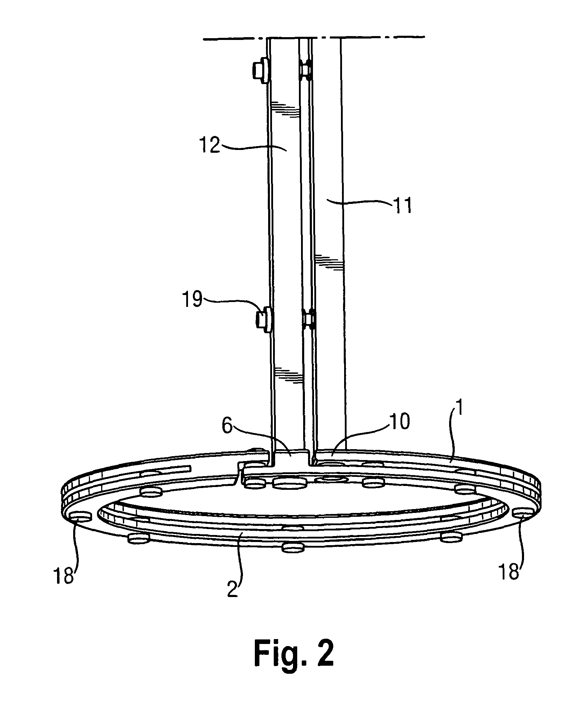

Fig.2 ist zu entnehmen, dass die Bohrungen größtenteils zur Aufnahme von Verbindungselementen 18 dienen, die den oberen Ring und den unteren Ring zusammenhalten, und zwar in einem bestimmten Abstand und so, dass sie voneinander elektrisch isoliert sind oder derart, dass die Verbindungselemente eine hochohmige Leitung zwischen den Ringen bilden. Die Bohrung auf der Stirnseite am Ende 10 des oberen Rings und die Bohrung auf der Stirnseite des Sockels 6 dienen zur Befestigung des oberen Rings 1 an eine Stromzuführung 11 des oberen Rings beziehungsweise zur Befestigung des unteren Rings 2 an eine Stromzuführung 12 des unteren Rings. Der Sockel 6 vergrößert die Dicke des unteren Rings 2 vorzugsweise derart, dass die Ringe an Stellen gleicher Höhe an den Stromzuführungen befestigt sind.

Bei dem in Fig.2 dargestellten Ringheizer sind die Stromzuführung 11 des oberen Rings und die Stromzuführung 12 des unteren Rings an mindestens einer Stelle mittels einer Klemmverbindung 19 miteinander verbunden. Die Klemmverbindung 19 sichert die Stromzuführungen gegen eine sie zusammendrückende elektromagnetische Kraft eines starken externen Magnetfelds. Zusätzlich oder an Stelle der Klemmverbindung 19 können eine oder mehrere Verbindungen der Stromzuführungen vorgesehen sein, die die Stromzuführungen gegen eine sie auseinanderdrückende elektromagnetische Kraft eines starken externen Magnetfelds sichern.

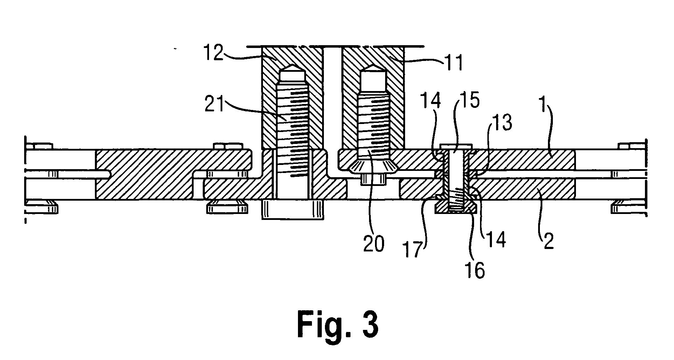

Die Verbindungselemente 18 umfassen gemäß Fig.3 vorzugsweise jeweils einen ringförmigen Abstandhalter 13, Hohlzylinder 14, eine Schraube 15 und eine Schraubenmutter 16. Der Durchmesser der Hohlzylinder 14 ist vorzugsweise an einem Ende durch einen Kragen 17 erweitert. Der ringförmige Abstandhalter 13 ist zwischen den Ringen angeordnet. Die Hohlzylinder sind durch die Bohrungen gesteckt und kleiden diese aus. Die Schraube 15, die sich durch die Hohlzylinder 14 und den Abstandhalter 13 erstreckt, ist an ihrem Ende mit der Schraubenmutter 16 verschraubt. Die Schraubenmutter ist vorzugsweise durch ein Sackloch geschlossen.

Beim Zusammenbau wird zunächst der ringförmige Abstandhalter 13 zwischen den oberen Ring 1 und den unteren Ring 2 geschoben und anschließend ein Hohlzylinder 14 durch die Bohrung im oberen Ring in den Abstandhalter gesteckt. Danach wird ein weiterer Hohlzylinder 14 durch den unteren Ring 2 in den Abstandshalter gesteckt und die Anordnung mit der Schraube 15 und der Schraubenmutter 16 verschraubt. Um an Bauhöhe einzusparen, sind die Kragen 17 der Hohlzylinder 14 in die Stirnseite des oberen Rings 1 und in die Gegenseite der Stirnseite des unteren Rings 2 eingelassen.

Die Hohlzylinder 14 und der ringförmige Abstandhalter 13 bestehen aus einem temperaturbeständigen und elektrisch isolierenden Material, vorzugsweise aus Bornitrid.

Die Schraube 15 und die Schraubenmutter 16 bestehen aus einem temperaturbeständigen und gegen Zug-, Schub- und Torsionsbelastung widerstandsfähigen Material, vorzugsweise aus mit Kohlenstofffasern verstärktem Kohlenstoff (CFC).

Der ringförmige Abstandhalter 13 nimmt Druckkräfte auf, die die Ringe unter der Einwirkung eines starken externen Magnetfelds zusammenpressen, und die Schraube 15 nimmt Zugkräfte auf, die die Ringe unter der Einwirkung eines starken externen Magnetfelds auseinanderziehen.

Die Stromzuführung 11 des oberen Rings 1 leitet eine vergleichsweise hohe Stromdichte in den oberen Ring. Das Befestigungsmittel zum Befestigen des oberen Rings 1 an der Stromzuführung 11 sollte daher temperaturbeständig sein und einen vergleichsweise niedrigen spezifischen Widerstand aufweisen. Es ist daher bevorzugt, den oberen Ring mit einer Schraube 20 aus Graphit an der Stromzuführung 11 zu befestigen. Darüber hinaus ist es von Vorteil, zur Vergrößerung der Kontaktfläche die Schraube 20 als Senkschraube auszubilden.

Die Stromzuführung 12 des unteren Rings 2 trägt einen Großteil des Gewichts des Ringheizers. Das Befestigungsmittel zum Befestigen des unteren Rings 2 an der Stromzuführung 12 sollte daher temperaturbeständig sein und eine vergleichsweise hohe mechanische Stabilität aufweisen. Es ist daher bevorzugt, den unteren Ring mit einer Schraube 21 aus mit Kohlenstofffasern verstärktem Kohlenstoff (CFC) an der Stromzuführung 12 zu befestigen.

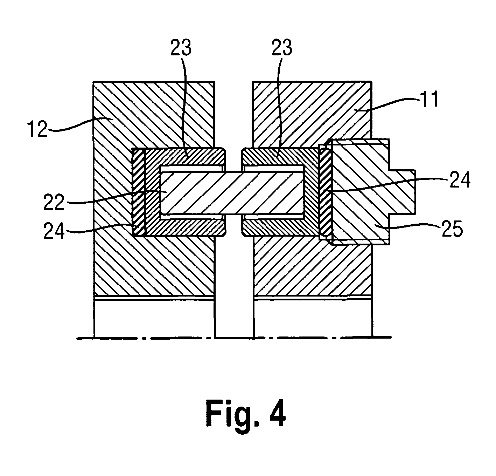

Die Klemmverbindung 19 umfasst gemäß Fig.4 einen Stift 22, der quer zur Längsrichtung der Stromzuführung 11 des oberen Rings und der Stromzuführung 12 des unteren Rings angeordnet ist und über den elektrisch isolierende Fassungen 23 gestülpt sind. Die Fassungen 23 stecken mit Scheiben 24 in Löchern der Stromzuführungen und werden durch eine Schraube 25 in Position gehalten. Der Stift 22 und die Scheiben 24 bestehen vorzugsweise aus mit Kohlenstofffasern verstärktem Kohlenstoff (CFC), die Fassungen 23 vorzugsweise aus Bornitrid.

### Beispiel:

Die mechanische Stabilität eines Ringheizers mit den Merkmalen der Darstellungen in den Fig.1 bis 4 wurde unter Bedingungen getestet, wie sie in dem in der US 2004/0192015 A1 beschriebenen Verfahren vorkommen. Bei vergleichbarer Leistungsfähigkeit zeigte sich eine geringere Verschleiß- und Störungsanfälligkeit des Ringheizers im Vergleich mit dem in der Druckschrift beschriebenen Ringheizer. Darüber hinaus konnte der in der Druckschrift beschriebene Ringheizer durch den erfindungsgemäßen Ringheizer ersetzt werden, ohne dass dafür bauliche Veränderungen an der Vorrichtung zur Herstellung von Einkristallen vorgenommen werden mussten.

## Patentansprüche

1. Ringförmiger Widerstandsheizer zum Zuführen von Wärme zu einem wachsenden Einkristall, umfassend einen oberen und einen unteren Ring (1, 2), die durch Ringspalte, die versetzt angeordnet sind, unterbrochen sind, und die angrenzend an den Ringspalt (3) des unteren Rings (2) mittels einer Schleife (4) elektrisch leitend verbunden sind, so dass die Fließrichtung von elektrischem Strom, der durch die Ringe geleitet wird, in den Ringen entgegengesetzt ist; Verbindungselemente (18), die den oberen und den unteren Ring (1, 2) auf Abstand zusammenhalten, wobei der Abstand nicht weniger als 2 mm und nicht mehr als 150 mm beträgt; und Stromzuführungen (11, 12) zum Leiten von elektrischem Strom durch den oberen und den unteren Ring (1, 2), wobei die Stromzuführungen (11, 12) elektrisch isoliert miteinander verbunden und auf diese Weise gegen eine sie zusammendrückende oder sie auseinanderziehende Kraft eines externen Magnetfelds gesichert sind.

2. Widerstandsheizer nach Anspruch 1, **dadurch gekennzeichnet, dass** der obere und der untere Ring (1, 2) und die Stromzuführungen (11, 12) im Wesentlichen aus Kohlenstoff bestehen.

3. Widerstandsheizer nach Anspruch 1 oder Anspruch 2, **dadurch gekennzeichnet, dass** Ränder des oberen und des unteren Rings (1, 2) abgerundet sind.

4. Widerstandsheizer nach einem der Ansprüche 1 bis 3, **dadurch gekennzeichnet, dass** die Verbindungselemente (18) jeweils einen ringförmigen Abstandhalter (13), Hohlzylinder (14), eine Schraube (15) und eine Schraubenmutter (16) umfassen, wobei der ringförmige Abstandhalter (13) zwischen den Ringen (1, 2) angeordnet ist, die Hohlzylinder (14) Bohrungen durch die Ringe in Dickenrichtung auskleiden, und die Schraube (15) an ihrem Ende mit der Schraubenmutter (16) verschraubt ist und sich durch die Hohlzylinder (14) und den Abstandhalter (13) erstreckt.

5. Widerstandsheizer nach Anspruch 4, **dadurch gekennzeichnet, dass** Krägen (17) der Hohlzylinder (14) in Seitenflächen des oberen und unteren Rings (1, 2) eingelassen sind.

6. Widerstandsheizer nach einem der Ansprüche 1 bis 5, **dadurch gekennzeichnet, dass** der obere und der untere Ring (1, 2) von Verbindungselementen (18) an einer Stelle zusammengehalten wird, die neben der Schleife (4) und neben der Stromzuführung (12) des unteren Rings (2) liegt.

7. Widerstandsheizer nach einem der Ansprüche 1 bis 6, **dadurch gekennzeichnet, dass** der obere Ring (1) mittels einer Schraube (20) aus Graphit an der Stromzuführung (11) des oberen Rings befestigt ist.

8. Widerstandsheizer nach einem der Ansprüche 1 bis 7, **dadurch gekennzeichnet, dass** der untere Ring (2) mittels einer Schraube (21) aus CFC an der Stromzuführung (12) des unteren Rings befestigt ist.

9. Widerstandsheizer nach einem der Ansprüche 1 bis 8, **gekennzeichnet durch** eine Klemmverbindung (19), die die Stromzuführungen (11, 12) miteinander verbindet und sie gegen eine sie zusammendrückende elektromagnetische Kraft sichert.

10. Widerstandsheizer nach Anspruch 9, **dadurch gekennzeichnet, dass** die Klemmverbindung (19) einen Stift (22) umfasst, der quer zur Längsrichtung der Stromzuführungen (11, 12) angeordnet ist und über den elektrisch isolierende Fassungen (23) gestülpt sind, und eine Schraube (25), die die Fassungen (23) und den Stift (22) in Position hält.

## Claims

1. Ring-shaped resistance heater for supplying heat to a growing single crystal, comprising
an upper and a lower ring (1, 2), which are interrupted by ring gaps arranged in an offset manner, and which are electrically conductively connected by means of a loop (4) adjacent to the ring gap (3) of the lower ring (2), such that the flow direction of electric current which is conducted through the rings is opposite in the rings;
connecting elements (18) which hold the upper and lower rings (1, 2) together at a distance, wherein the distance is not less than 2 mm and not more than 150 mm; and
current leads (11, 12) for conducting electric current through the upper and lower rings (1, 2), wherein the current leads (11, 12) are connected to one another in an electrically insulated manner and are secured in this way against a force of an external magnetic field which compresses them or pulls them apart.

2. Resistance heater according to Claim 1, **characterized in that** the upper and lower rings (1, 2) and the current leads (11, 12) substantially consist of carbon.

3. Resistance heater according to Claim 1 or Claim 2, **characterized in that** edges of the upper and lower rings (1, 2) are rounded.

4. Resistance heater according to any of Claims 1 to 3, **characterized in that** the connecting elements (18) each comprise a ring-shaped spacer (13), hollow cylinders (14), a screw (15) and a screw nut (16), wherein the ring-shaped spacer (13) is arranged between the rings (1, 2), the hollow cylinders (14) line holes through the rings in the thickness direction, and the screw (15) is screwed at its end to the screw nut (16) and extends through the hollow cylinders (14) and the spacer (13).

5. Resistance heater according to Claim 4, **characterized in that** collars (17) of the hollow cylinders (14) are countersunk in side areas of the upper and lower rings (1, 2).

6. Resistance heater according to any of Claims 1 to 5, **characterized in that** the upper and lower rings (1, 2) are held together by connecting elements (18) at a location which lies alongside the loop (4) and alongside the current lead (12) of the lower ring (2).

7. Resistance heater according to any of Claims 1 to 6, **characterized in that** the upper ring (1) is fixed to the current lead (11) of the upper ring by means of a screw (20) composed of graphite.

8. Resistance heater according to any of Claims 1 to 7, **characterized in that** the lower ring (2) is fixed to the current lead (12) of the lower ring by means of a screw (21) composed of CFC.

9. Resistance heater according to any of Claims 1 to 8, **characterized by** a clamping connection (19), which connects the current leads (11, 12) to one another and secures them against an electromagnetic force compressing them.

10. Resistance heater according to Claim 9, **characterized in that** the clamping connection (19) comprises a pin (22), which is arranged transversally with respect to the longitudinal direction of the current leads (11, 12) and over which electrically insulating mounts (23) are slipped, and a screw (25), which holds the mounts (23) and the pin (22) in position.

## Revendications

1. Dispositif annulaire de chauffage à résistance destiné à apporter de la chaleur à un monocristal en croissance et comprenant
un anneau supérieur et un anneau inférieur (1, 2) interrompus par des interstices annulaires disposés en décalage et raccordés électriquement au moyen d'une boucle (4) en position adjacente à l'interstice annulaire (3) de l'anneau inférieur (2) de telle sorte que les directions d'écoulement du courant électrique amené dans les anneaux soient opposées dans les anneaux,
des éléments de raccordement (18) qui maintiennent l'anneau supérieur et l'anneau inférieur (1, 2) à distance mutuelle, la distance n'étant pas inférieure à 2 mm ni supérieure à 150 mm et
des amenées de courant (11, 12) qui amènent un courant électrique dans l'anneau supérieur et l'anneau inférieur (1, 2),
les amenées de courant (11, 12) étant raccordées l'une à l'autre de manière électriquement isolée et étant ainsi protégées de la force d'un champ magnétique externe qui les rapprocherait ou les écarterait.

2. Dispositif de chauffage à résistance selon la revendication 1, **caractérisé en ce que** l'anneau supérieur et l'anneau inférieur (1, 2) ainsi que les amenées de courant (11, 12) sont essentiellement constitués de carbone.

3. Dispositif de chauffage à résistance selon la revendication 1 ou la revendication 2, **caractérisé en ce que** les bords de l'anneau supérieur et de l'anneau inférieur (1, 2) sont arrondis.

4. Dispositif de chauffage à résistance selon l'une des revendications 1 à 3, **caractérisé en ce que** les éléments de raccordement (18) comportent chacun un écarteur annulaire (13), un cylindre creux (14), un écrou (15) et un boulon (16), l'écarteur annulaire (13) étant disposé entre les anneaux (1, 2), les cylindres creux (14) recouvrant dans la direction de l'épaisseur des alésages traversant les anneaux et la vis (15) étant vissée à l'écrou (16) à son extrémité et s'étendant à travers les cylindres creux (14) et l'écarteur (13).

5. Dispositif de chauffage à résistance selon la revendication 4, **caractérisé en ce que** des collets (17) du cylindre creux (14) sont ménagés dans les surfaces latérales de l'anneau supérieur et de l'anneau inférieur (1, 2).

6. Dispositif de chauffage à résistance selon l'une des revendications 1 à 5, **caractérisé en ce que** l'anneau supérieur et l'anneau inférieur (1, 2) sont maintenus ensemble par des éléments de raccordement (18) en un emplacement situé à côté de la boucle (4) et à côté de l'amenée de courant (12) de l'anneau inférieur (2).

7. Dispositif de chauffage à résistance selon l'une des revendications 1 à 6, **caractérisé en ce que** l'anneau supérieur (1) est fixé au moyen d'une vis (20) en graphite sur l'amenée de courant (11) de l'anneau supérieur.

8. Dispositif de chauffage à résistance selon l'une des revendications 1 à 7, **caractérisé en ce que** l'anneau inférieur (2) est fixé au moyen d'une vis (21) en CFC sur l'amenée de courant (12) de l'anneau inférieur.

9. Dispositif de chauffage à résistance selon l'une des revendications 1 à 8, **caractérisé par** un raccordement serré (19) qui relie l'une à l'autre les amenées de courant (11, 12) et qui les protègent d'une force électromagnétique qui les rapprocherait.

10. Dispositif de chauffage à résistance selon la revendication 9, **caractérisé en ce que** le raccordement serré (19) comporte une tige (22) disposée transversalement par rapport au sens de la longueur des amenées de courant (11, 12) et au-dessus de laquelle des sertissages électriquement isolants (23) sont placés, une vis (25) qui maintient en position les sertissages (23) et la tige (22).
